**Europäisches Patentamt**

**European Patent Office**

**Office européen des brevets**

(19)

(11) Numéro de publication: **0 060 153**
**A1**

(12) **DEMANDE DE BREVET EUROPEEN**

(21) Numéro de dépôt: **82400206.7**

(22) Date de dépôt: **05.02.82**

(51) Int. Cl.³: **H 03 B 21/00**

(30) Priorité: **24.02.81 FR 8103621**

(43) Date de publication de la demande:
**15.09.82 Bulletin 82/37**

(84) Etats contractants désignés:
**DE GB NL**

(71) Demandeur: **THOMSON-CSF**
**173, Boulevard Haussmann**
**F-75360 Paris Cedex 08(FR)**

(72) Inventeur: **Kantorowicz, Gérard**
**THOMSON-CSF SCPI 173, bld Haussmann**
**F-75360 Paris Cedex 08(FR)**

(72) Inventeur: **Funck, Ronald**
**THOMSON-CSF SCPI 173, bld Haussmann**
**F-75360 Paris Cedex 08(FR)**

(72) Inventeur: **Obregon, Juan**
**THOMSON-CSF SCPI 173, bld Haussmann**
**F-75360 Paris Cedex 08(FR)**

(74) Mandataire: **Giraud, Pierre et al,**
**THOMSON-CSF SCPI 173, Bld Haussmann**
**F-75360 Paris Cedex 08(FR)**

(54) Diviseur de fréquence analogique utilisant un transistor à effet de champ bigrille en très haute fréquence.

(57) L'invention concerne un diviseur de fréquence du type analogique (par opposition aux diviseurs numériques) où l'on se sert d'un transistor à effet de champ à deux grilles pour diviser, notamment par un facteur deux, une fréquence très élevée par exemple de l'ordre de 3 à 20 GHz.

On utilise à cet effet le deuxième grille ($G_2$) pour introduire le signal à la fréquence originelle (F) et on relie la première grille ($G_1$) du transistor au drain D à travers un élément (24) sélectionnant la fréquence sous-harmonique (F/2). Un filtrage complémentaire (12) est assuré à la sortie du diviseur.

Application aux circuits hyperfréquence, en particulier aux synthétiseurs de fréquence à génération directe en hyperfréquence.

**FIG.4**

EP 0 060 153 A1

# DIVISEUR DE FREQUENCE ANALOGIQUE UTILISANT UN TRANSISTOR A EFFET DE CHAMP BIGRILLE EN TRES HAUTE FREQUENCE

L'invention concerne un diviseur de fréquence du type analogique (par opposition aux diviseurs de fréquence dits numériques) où l'on se sert d'un transistor à effet de champ à deux grilles pour diviser, notamment par un facteur 2, une fréquence très élevée par exemple de l'ordre de 3 à 20 GHz, si le transistor à effet de champ à deux grilles est conçu pour fonctionner jusqu'à cette fréquence maximum.

Les diviseurs numériques utilisent des circuits du type "bascule" comportant plusieurs composants et présentant des temps de propagation non négligeables en très haute fréquence, ce qui limite la fréquence d'utilisation de ces diviseurs.

Les diviseurs de fréquence analogiques connus comportent un mélangeur, un amplificateur, un filtre et une boucle de réaction.

Le mélangeur est du type de ceux qui sont utilisés dans les récepteurs pour transposer la fréquence porteuse du signal à recevoir sur une fréquence dite intermédiaire. A cet effet, le mélangeur constitué par exemple par une paire de diodes comporte une entrée "signal", une entrée "fréquence locale", et une sortie "moyenne fréquence". Dans le cas de la division par deux la boucle de réaction est montée entre la sortie du filtre et l'entrée "fréquence locale" du mélangeur. Un tel montage n'est limité en fréquence que par l'amplificateur, le filtre étant, quant à lui, calculé en conséquence.

L'invention introduit une simplification notable de ce dernier type de diviseur, en intégrant dans un seul composant, les fonctions de mélange et d'amplification.

L'invention propose un diviseur analogique dans lequel on module le gain d'un amplificateur par un signal d'entrée comportant la fréquence originelle à diviser, le signal amplifié étant filtré de manière à favoriser une fréquence sous-harmonique prédéterminée F/N de la fréquence originelle, une partie du signal amplifié étant prélevée pour être introduite à l'entrée du diviseur par une boucle de réaction comportant un élément sélectif

.2

favorisant ladite fréquence sous-harmonique ou un multiple M entier de cette fréquence sous-harmonique dans la relation M = N - 1.

Le diviseur suivant l'invention est caractérisé en ce qu'il comprend un transistor à effet de champ comportant une première grille reliée à l'entrée du signal à la fréquence originelle et une deuxième grille reliée à la boucle de réaction.

L'invention sera mieux comprise, et d'autres caractéristiques apparaîtront, au moyen de la description qui suit, et des dessins qui l'accompagnent, parmi lesquels :

- la figure 1 représente l'art connu ;

- les figures 2 et 3 sont des schémas généraux de réaction ;

- la figure 4 représente une première réalisation de l'invention ;

- la figure 5 représente une deuxième réalisation de l'invention ;

- les figures 6 et 7 représentent des variantes de la première réalisation ;

- la figure 8 représente une troisième réalisation de l'invention.

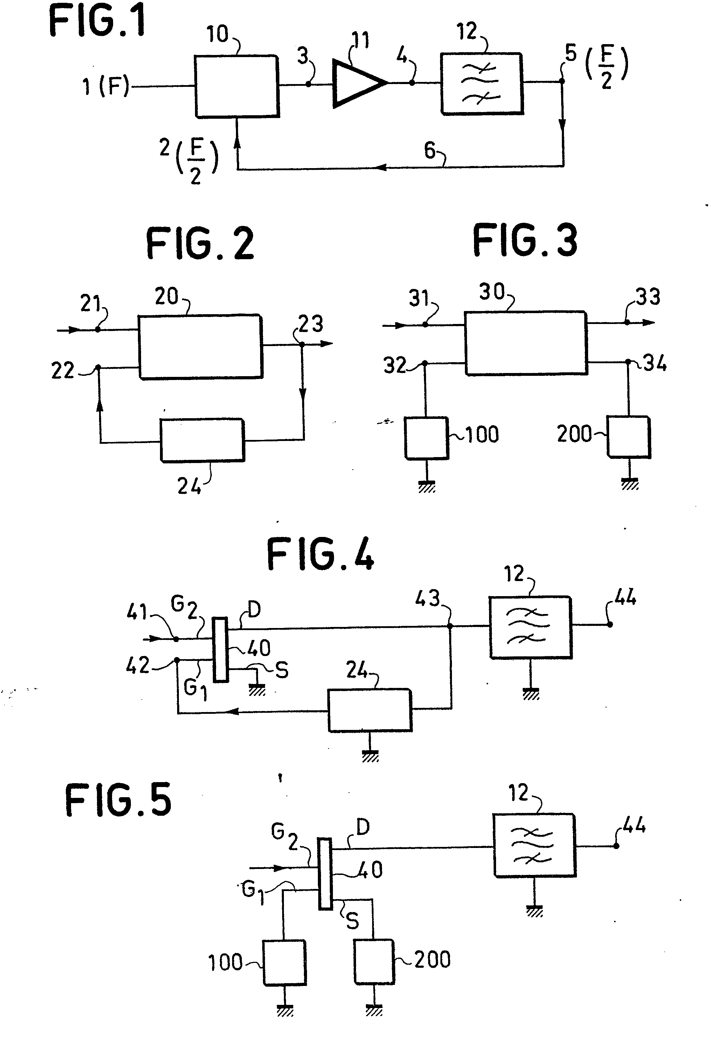

Sur la figure 1, on a représenté schématiquement un diviseur par deux, comportant un mélangeur 10, un amplificateur 11, un filtre 12 et une boucle de réaction 6. Dans ce schéma, de type unifilaire, les entrées ou sorties numérotées de 1 à 5 représentent respectivement :

1 : la paire de bornes d'entrée d'un signal à la fréquence F ;

2 : l'entrée d'un signal à la fréquence F/2 ;

3 : la sortie du mélangeur 10 raccordée à l'entrée de l'amplificateur 11 ;

4 : la sortie de l'amplificateur 11 raccordée à l'entrée du filtre 12 ;

5 : la sortie du filtre 12 raccordée à l'entrée 2 du mélangeur 10.

On rappelle que le fonctionnement est basé sur le fait qu'une oscillation, apparaissant sur une fréquence sous-harmonique du signal à la fréquence F, et démarrant soit sur un transitoire ou sur du bruit, est amplifiée, filtrée et régénérée par le mélangeur, favorisant ainsi la fréquence F/2 à l'exclusion du toute autre, uniquement lorsque la fréquence F est appliquée à la borne 1.

La largeur de bande du diviseur, c'est-à-dire le domaine de fréquence de division, est limitée par la boucle, notamment par le filtre.

3

La figure 2 représente un schéma du type "réaction classique" aux bornes (chaque borne représentant une paire de pôles) d'un hexapôle 20, à deux entrées (21, 22) et une sortie . Un quadripôle 24, placé sur la boucle de réaction entre les bornes 22 et 23, représente un élément de filtrage sélectionnant par exemple la fréquence F/2.

Ce schéma s'applique à la réalisation de l'invention représentée à la figure 4 où l'on voit un transistor à effet de champ à deux grilles $G_1$ et $G_2$ constituant avec l'électrode D de drain, l'électrode S de source étant reliée à la masse, les bornes d'un hexapôle.

Dans cette réalisation, le signal à la fréquence F est introduit entre une borne 41 reliée à la grille $G_2$ et la masse, la boucle de réaction comportant l'élément 24 branché entre la borne 42 reliée à la grille $G_1$ et la borne 43 reliée au drain D, et à l'entrée du filtre 12 de sortie 44. On notera que la masse constitue ici le deuxième pôle de l'ensemble des bornes 41 à 44.

Le fonctionnement en diviseur par deux de cette réalisation est le suivant : le transistor à effet de champ cumule les fonctions de mélangeur et d'amplificateur. En effet, si les tensions de crête des signaux appliqués aux grilles $G_1$ et $G_2$, restent inférieures à des valeurs connues pour le transistor utilisé, le phénomène de mélange aura lieu, une intermodulation des signaux de fréquence F et de fréquence F/2, filtrée par la boucle de réaction 24, produisant entre autres la fréquence F/2. Ces produits d'intermodulation apparaissent entre drain et source en bénéficiant de l'amplification caractéristique du transistor, l'oscillation à la fréquence F/2 dans la boucle de réaction 24 n'apparaissant que lorsque la fréquence F est appliquée sur la grille $G_2$

L'élément 24 constitue avec la masse un quadripôle qui joue un double rôle de filtrage et d'adaptation d'impédance entre les côtés "grille" et "drain" de l'élément 24 sur la fréquence F/2 comme dans la réalisation citée, ce qui peut plus généralement se faire sur une fréquence multiple d'un sous-harmonique MF/N.

La figure 3 représente un schéma de la figure 2 s'appliquant à un octopôle 30, avec une réalisation quelque peu différente de la réaction ou contre-réaction par rapport à la figure 2. La réalisation diffère sur le point suivant :

on a intercalé des éléments d'impédance 100 et 200 entre les bornes 32 et 34 et la masse, créant ainsi une réaction ou contre -réaction de type "série". L'un de ces éléments par exemple est résistif, l'un au moins étant sélectif.

Ce schéma s'applique à la réalisation de la figure 5, où l'on trouve, comme dans la réalisation de la figure 4, un transistor 40 et un filtre 12. Mais ici la boucle de réaction entre drain et grille est remplacée par une réaction entre source et grille. Comme à la figure 3 on intercale des éléments 100 et 200 respectivement entre grille $G_1$ et masse, et entre source S et masse. L'un des éléments, ou les deux, sont déterminés théoriquement ou expérimentalement pour obtenir le taux de réaction le plus favorable sur la fréquence sous harmonique tout en favorisant l'obtention en sortie sur le drain du sous-harmonique choisi.

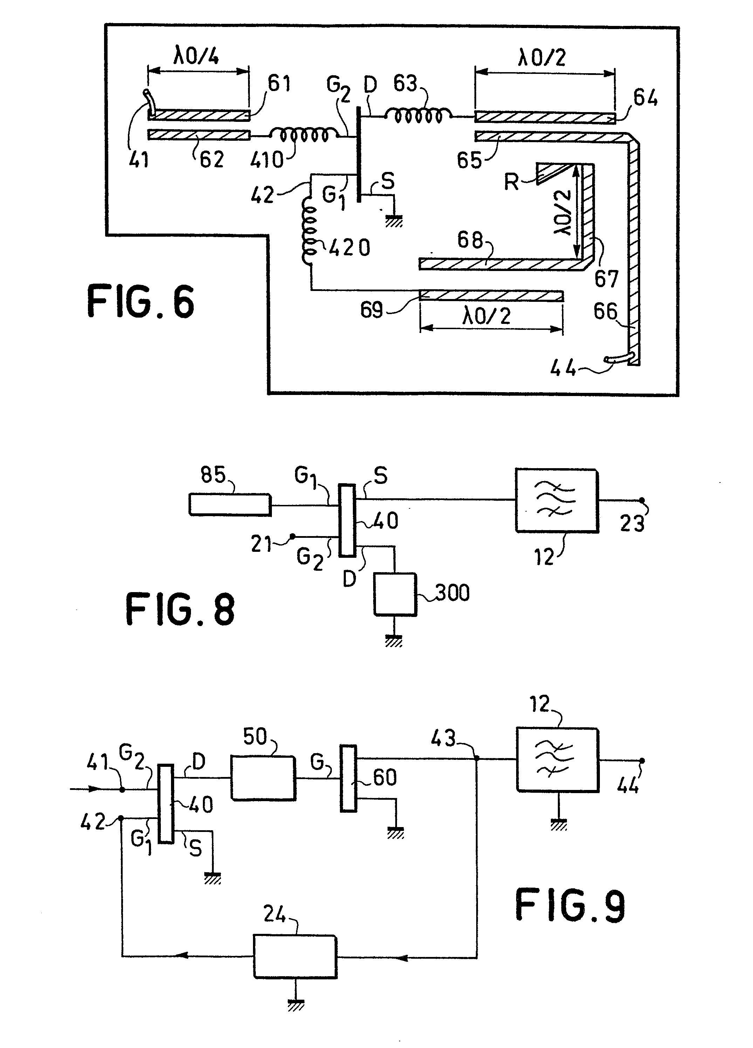

Dans la réalisation de la figure 6, qui est une variante de celle de la figure 4, dans laquelle les mêmes références désignent les mêmes éléments, l'ensemble de la boucle de réaction 24, et du filtre 12, est constitué par des éléments de ligne microbande (réalisés par exemple en dépôts métalliques sur plaque d'alumine comportant un plan de masse inférieur), ces éléments étant disposés comme suit :

- ligne demi-onde 64 (à la fréquence F) parallèle à l'élément 65 raccordé à angle droit en 66, ce qui donne un premier filtre naturel à la fréquence F, la fréquence F/2 n'étant pas affaiblie en raison du fait qu'une ligne demi-onde pour la fréquence F est une ligne quart d'onde pour la fréquence F/2 ;

- élément 67 en ligne demi-onde à la fréquence F, parallèle à l'élément 66 de longueur bien supérieure, l'élément 67 se raccordant à angle droit avec un élément 68, disposition où l'on trouve un deuxième filtre naturel à F ;

- l'élément 69 parallèle sur une demi-longueur d'onde à l'élément 68 constituant ainsi un troisième filtre naturel à la fréquence F.

Enfin, on a ajouté un découplage capacitif par deux éléments parallèle en quart d'onde (61 et 62) à l'entrée de la grille $G_2$, et une charge R (dépôt de nickel-chrome) à l'extrémité libre de l'élément 67.

Des inductances de 1 nH sont montées, sous la forme de simples boucles de fil d'or, en 410 sur la grille $G_2$ et en 420 sur la grille $G_1$, ainsi qu'en 63 sur le drain D. On utilise par exemple du fil d'or de 50 microns de

7

REVENDICATIONS

1. Diviseur analogique de fréquence dans lequel on module le gain d'un amplificateur par un signal d'entrée introduit sur une première entrée du diviseur et contenant la fréquence originelle à diviser, le signal amplifié étant filtré de manière à favoriser une fréquence sous-harmonique prédéterminée de la fréquence originelle et des multiples entiers de cette fréquence sous-harmonique, une partie du signal amplifié et filtré étant prélevée pour être introduite sur une deuxième entrée du diviseur par une boucle de réaction (23, 24, 22) comportant un élément sélectif (24) favorisant ladite fréquence sous-harmonique ou un multiple entier de cette fréquence sous--harmonique, le diviseur étant caractérisé en ce qu'il comprend un transistor (40) à effet de champ comportant une première grille ($G_1$) reliée à la boucle de réaction et une deuxième grille ($G_2$) reliée à la première entrée, la deuxième grille ($G_2$) étant plus près du drain du transistor que la première grille ($G_1$).

2. Diviseur selon la revendication 1, caractérisé en ce que le drain (D) du transistor (40) est relié à l'élément sélectif (24) de la boucle de réaction.

3. Diviseur selon la revendication 1, caractérisé en ce que la source (S) du transistor (40) est reliée par couplage interne à la première grille $G_1$ elle-même chargée par un élément sélectif favorisant ladite fréquence sous-harmonique ou un multiple entier de celle-ci.

4. Diviseur selon la revendication 1, caractérisé en ce qu'une première impédance (100) est placée entre la première grille ($G_1$) et la masse, et une deuxième impédance (200) est placée entre la source (S) et la masse, l'une au moins d'entre elles étant sélective et favorisant ladite sous-harmonique.

5. Diviseur selon la revendication 2, caractérisé en ce qu'il comporte en outre un étage d'amplification complémentaire entre le drain (D) du transistor (40) et la sortie (44) du diviseur.

6. Diviseur selon la revendication 1, caractérisé en ce qu'il comporte un double étage d'amplification intégré sur le même substrat semi-conducteur.

## FIG.1

1 (F) — 10 — 3 — ▷ 11 — 4 — 12 (≈≈) — 5 $\left(\frac{F}{2}\right)$

$2\left(\frac{F}{2}\right)$ — 6

## FIG.2

21 — 20 — 23

22 — 24

## FIG.3

31 — 30 — 33

32 — 100    200 — 34

## FIG.4

41 $G_2$ — D — 43 — 12 (≈≈) — 44

42 — 40 — S

$G_1$ — 24

## FIG.5

$G_2$ — D — 40 — 12 (≈≈) — 44

$G_1$ — S

100    200

FIG.6

FIG.8

FIG.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| | US - A - 3 863 136 (HANSON) | | |
| X | * colonne 1, ligne 1 - colonne 3, ligne 27; figures 1,2 * | 1,2 | H 03 B 21/00 |
| Y | | 3-6 | |
| | -- | | |
| | INSTRUMENTS AND EXPERIMENTAL TECHNIQUES, volume 21, no. 2/2, mars/avril 1978 PLENUM PUBL. CORP. NEW YORK (US) V.V. INOZEMTSEV "Frequency divider using dual-gate field-effect transistor" pages 439-140 | | |
| X | * en entier * | 1,2 | |
| Y | | 3-6 | |
| | -- | | |
| Y | PATENTS ABSTRACTS OF JAPAN, volume 4, no. 59, 2 mai 1980, page 120E9 & JP - A - 55030206 (FUJITSU) | | **DOMAINES TECHNIQUES RECHERCHES (Int. Cl. 3)** |
| | * en entier * | 1,3,4 | |
| | -- | | H 03 B |
| Y | 9th EUROPEAN MICROWAVE CONFERENCE, Brighton, 17-20 septembre 1979 SEVENOAKS (GB) CH. TSIRONIS et al. "A self-oscillating dual gate MESFET X-band mixer with 12DB conversion gain" pages 321-325 | | H 03 L |
| | * page 321, ligne 13 - page 323, ligne 23; figure 2 * | 3,4 | |
| | -- | | |
| | ./. | | |

Le présent rapport de recherche a été établi pour toutes les revendications

| Lieu de la recherche | Date d'achèvement de la recherche | Examinateur |
|---|---|---|
| La Haye | 27-05-1982 | DHONDT |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&  membre de la même famille, document correspondant

OEB Form 1503 03 82

Office européen
des brevets

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendica-tion concernée | |
| Y | 10th EUROPEAN MICROWAVE CONFERENCE, Warchau, 08-12 septembre 1980 SEVENOAKS (GB) J. NOORDANUS et al. "Hybrid MIC's for a 6GHz phase locked divider loop" pages 613-617 | | |
| | * page 615, ligne 1 - page 616, ligne 11; figures 6,7 * | 5,6 | |
| | -- | | |
| A | FR - A - 1 295 088 (GENERAL ELEC-TRIC) | | |
| | | | DOMAINES TECHNIQUES RECHERCHES (Int. Cl.³) |
| | * en entier * | 1 | |
| | -- | | |
| A | US - A - 3 305 730 (PARZEN) | | |
| | * en entier * | 1 | |
| | -- | | |
| A | DE - A - 1 816 039 (TELEFUNKEN) | | |
| | * en entier * | 1 | |
| | ------------ | | |